Europäisches Patentamt

European Patent Office

Office européen des brevets

(11) Veröffentlichungsnummer: **0 199 132**
**B1**

(12) **EUROPÄISCHE PATENTSCHRIFT**

(45) Veröffentlichungstag der Patentschrift: **07.11.90**

(21) Anmeldenummer: **86104142.4**

(22) Anmeldetag: **25.03.86**

(51) Int. Cl.⁵: **C 23 C 18/18, C 25 D 15/02**

(54) Verfahren zur nasschemischen Herstellung einer Metallschicht.

(30) Priorität: **13.04.85 DE 3513266**
**24.05.85 DE 3518767**

(43) Veröffentlichungstag der Anmeldung:
**29.10.86 Patentblatt 86/44**

(45) Bekanntmachung des Hinweises auf die
Patenterteilung:
**07.11.90 Patentblatt 90/45**

(84) Benannte Vertragsstaaten:
**AT BE CH DE FR GB IT LI LU NL SE**

(56) Entgegenhaltungen:
**DE-A-2 150 145     US-A-3 723 078**
**FR-A-1 551 555     US-A-3 753 816**
**FR-A-2 179 107     US-A-4 153 453**
**GB-A-1 253 505**

Die Akte enthält technische Angaben, die nach
dem Eingang der Anmeldung eingereicht
wurden und die nicht in dieser Patentschrift
enthalten sind.

(73) Patentinhaber: **Licentia Patent-Verwaltungs-
GmbH
Theodor-Stern-Kai 1
D-6000 Frankfurt/Main 70 (DE)**

(72) Erfinder: **Bogenschütz, August Friedrich, Prof.
Dr. rer. nat.
Beethovenstrasse 10
D-7931 Oberdischingen (DE)**
Erfinder: **Schödlbauer, Reinhard
Kirchplatz 15
D-7919 Bellenberg (DE)**
Erfinder: **Ostwald, Robert, Dr.-Ing.
Hasensteige 8
D-7900 Ulm (DE)**
Erfinder: **Voit, Gabriele
Buchenweg 6
D-7950 Biberach 18 (DE)**

(74) Vertreter: **Schulze, Harald Rudolf, Dipl.-Ing. et al
Licentia Patent-Verwaltungs-GmbH Theodor-
Stern-Kai 1
D-6000 Frankfurt/Main 70 (DE)**

(56) Entgegenhaltungen:

**IBM TECHNICAL DISCLOSURE BULLETIN, Band
20, Nr. 8, Januar 1978, Seite 3079, New York,
US; M.M. HADDAD et al.: "Depositing crack-free
heavy electroless nickel coating"**

**Beschreibung**

Die Erfindung betrifft ein Verfahren zur naßchemischen Metallisierung nach dem Oberbegriff des Patentanspruchs 1.

Verschiedene, auch nichtmetallische Unterlagenmaterialien werden zur Erzielung bestimmter funktioneller oder dekorativer Eigenschaften mit Metallschichten versehen. Diese müssen dann bei der Weiterverarbeitung oder der praktischen Anwendung den unterschiedlichsten Beanspruchungen standhalten. Insbesondere ist eine ausreichend hohe und auch beständige Haftung zwischen Unterlagenmaterial und Metallschicht eine Grundvoraussetzung für die praktische Anwendung. Die Haftung muß vor allem auch bei den hohen mechanischen Belastungen ausreichend sein, die bei thermischer Beanspruchung durch hohe Temperaturen oder bei Temperaturwechsel auftreten können.

In der Regel sind die Haftfestigkeit von Metallschichten auf nichtmetallischen Unterlagen nicht hoch genug, um bei thermischer Beanspruchung, wie sie z.B. beim Weichlöten auftritt, eine Blasenbildung der Metallschicht verhindern zu können. Aus diesem Grund kommen derzeit bei thermischer Beanspruchung von Nichtleitermetallisierungen für deren Herstellung lediglich apparativ aufwendige und wenig wirtschaftliche Verfahren wie z.B. die Vakuumaufdampf-, Kathodenzerstäubungs- oder die CVD-Technik in Frage.

Aus der FR—A—2 179 107 ist ein Verfahren zur naßchemischen Metallisierung einer elektrisch isolierenden Oberfläche bekannt, das insbesondere zur Herstellung von magnetisierbaren Schichten auf sehr glatten Oberflächen geeignet ist. Diese haft- und abriebfesten Schichten werden als Datenträger verwendet. Zu deren Herstellung wird zunächst die sehr glatte Oberfläche z.B. einer Glasplatte, gereinigt und darauf chemisch stromlos eine Keimschicht abgeschieden. Auf dieser wird ebenfalls chemisch stromlos eine dünne Basisschicht, z.B. eine Ni-P-Schicht, abgeschieden, die eine sehr gute Haftung auf der Oberfläche bewirkt. Auf der Basisschicht wird dann eine magnetisierbare Metallschicht und darauf möglicherweise zusätzlich eine metallische Verschleißschicht abgeschieden. Nach dem Abscheiden einzelner Schichten oder Schichtenfolge erfolgt eine Wärmebehandlung, die eine gute Haftfestigkeit sowie eine hohe Verschleißun Kratzfestigkeit bewirkt.

Der Erfindung liegt die Aufgabe zugrunde, ein gattungsgemäßes Verfahren anzugeben, das insbesondere auf elektrisch isolierenden Unterlagen eine wirtschaftlich herstellbare naßchemische Metallisierung ermöglicht, die eine möglichst hohe Haftfestigkeit besitzt und die thermisch belastbar ist, insbesondere durch einen in der Elektrotechnik geläufigen Weichlötvorgang.

Diese Aufgabe wird gelöst durch die im kennzeichnenden Teil des Patentanspruchs 1 angegebenen Merkmale. Zweckmäßige Ausgestaltungen und Weiterbildungen sind den Unteransprüchen entnehmbar.

Die Erfinding beruht auf der Erkenntnis, daß als Ursache für mechanische Spannungen zwischen der Unterlage und der Metallschicht nicht nur Unterschiede im thermischen Ausdehnungsverhalten in Frage kommen, sondern auch Veränderungen in den Materialien selbst sowie gasförmige Ausscheidungen zwischen diesen. So werden bei der galvanischen Abscheidung von Metallen mehr oder weniger große Mengen Wasserstoff sowie verschiedene, meist organische Elektrolyt-Zusätze in die Metallschicht mit eingebaut. Auch Elektrolyt- und/oder Wasserreste können während der Abscheidung eingelagert werden, insbesondere auf aufgerauhten Unterlagen. Alle diese Substanzen können dann, je nach angewandter Temperatur, durch Abspaltung, Verdampfung und/oder Zersetzung einen hohen Gasdruck verursachen, der entweder ohne Zerstörung der Metallschicht durch Diffusion oder einen anderen Abtransport der Gase abgebaut werden kann oder die Schicht vom Unterlagenmaterial mehr oder weniger großflächig trennt. Je besser die Haftfestigkeit ist, desto höher kann die angewandte Temperatur sein. Eine möglichst hohe Temperatur ist insbesondere für Löt- und Schweißprozesse wichtig.

Die Erfindung ermöglicht insbesondere auf Keramikunterlagen (Keramiksubstraten) eine blasenfreie naßchemische Kupfer-Metallisierung, deren Haftfestigkeit erhalten bleibt bei einem beispielhaften Weichlötvorgang bei ungefähr 280°C sowie einer Lötzeit von ungefähr 20 sec oder auch einem Hartlötprozeß von ca. 5 sec bei 400°C.

Die Erfindung wird im folgenden anhand von Ausführungsbeispielen näher erläutert:

Beispiel 1

Keramiksubstrate aus Aluminiumoxid (99,5% $Al_2O_3$) mit einer Dicke von ungefähr 0,6 mm werden durch Tauchen in einer Natriumhydroxidschmelze in bekannter Weise von der glasartigen "Brennhaut" befreit und mit Ultraschall-Unterstützung in demineralisiertem Wasser gründlich gespült. Durch aufeinander folgende Behandlungen in einer Lösung von Zinn-II-chlorid, Wasser und einer Lösung von Palladiumchlorid sowie abschließendem Spülen in demineralisiertem Wasser entsteht nach bekanntem Verfahren eine für chemisch stromlose Metallabscheidungen katalytisch wirkende Keimschicht auf der Keramikoberfläche. Auf dieser wird aus einem derzeit handelsüblichen chemischen Kupferbad eine ungefähr 0,3 μm dicke Kupfer-Basisschicht abgeschieden. Anschließend wird eine galvanische Vorverstärkung dieser Schicht auf ungefähr 2 μm Kupfer aus einem Elektrolyten folgender Zusammensetzung durchgeführt:

100 g/l Kupferdiphosphat
280 g/l Kaliumdiphosphat
15 g/l Kaliumnitrat
2 ml/l konz. Ammoniaklösung

Die Abscheidung wird bei einem pH-Wert von 8,7, einer Badtemperatur von 60°C und mit einer Stromdichte von 2 A/dm² durchgeführt. Diese Schicht wird nach dem Spülen in demineralisiertem Wasser getrocknet und unter Stickstoff bei 300°C für 15 Minuten getempert. Danach wird aus dem erwähnten Bad auf eine Gesamtschichtdicke von ungefähr 15 µm verstärkt. Die Kupferschichten werden bei 400°C unter Stickstoff für 10 Minuten getempert. Sie sind blasenfrei und von einwandfreiem Aussehen. nach einer fotoätztechnischen Herstellung von Metallstreifen können diese mit einer Schälkraft von ungefähr 0,5 N/mm von der Keramikoberfläche getrennt werden.

Beispiel 2

Keramiksubstrate aus Aluminiumoxid werden wie in Beispiel 1 vorbehandelt und durch chemisch stromlose Abscheidung mit einer Kupfer-Basisschicht versehen. Die galvanische Verstärkung auf eine Schichtdicke von ungefähr 15 µm wird aus einem Elektrolyten mit der folgenden Zusammensetzung vorgenommen:

> 240 g/l Kupferfluoroborat
> 20 g/l Fluoroborsäure
> 20 g/l Borsäure
> pH=1,0

Zusätzlich werden 5 g/l eines feindispersen Aluminiumoxids dessen Teilchendurchmesser kleiner als 10 µm ist und vorzugsweise in einem Bereich von 1 µm bis 5 µm liegt, durch starkes Rühren im Elektrolyten suspendiert. Die Abscheidung erfolgt bei 30°C und mit einer Stromdichte von 5 A/dm². Die Kupferschichten zeigen eine gleichmäßig seidenmattes Aussehen, haben nach einer thermischen Beanspruchung von 20 Minuten bei 400°C unter Stickstoff eine Schälkraft von 0,6 N/mm und sind frei von Blasen.

Beispiel 3

Keramiksubstrate werden wie in Beispiel 1 vorbehandelt und mit einer Kupfer-Basisschicht versehen. Der Kupferelektrolyt von Beispiel 1 wird anstatt mit konzentrierter Ammoniaklösung tropfenweise mit 1%iger Kaliumhydroxidlösung bis zu einem pH-Wert von 8,7 versetzt. Der Elektrolyt wird durch ein Kolloid aus basischem Kupferphosphat milchig trüb. Die Substrate werden in diesem Eletkrolyten bei 60°C und einer Stromdichte von 2A/dm² ohne Unterbrechung auf eine Gesamtschichtdicke von 15 µm verstärkt. Die Kupferschichten haben ein seidenmattes Aussehen und sich nach einer thermischen Beanspruchung von 20 Minuten bei 400°C unter Stickstoff frei von Blasen und zeigen eine Schälkraft von 0,5 N/mm.

Beispiel 4

Keramiksubstrate aus Aluminiumoxid (99,5% AlO₃) mit einer Dicke von ungefähr 0,6 mm werden durch Tauchen in eine Natriumhydroxidschmelze in bekannter Weise von der glasartigen "Brennhaut" befreit und mit Ultraschallunterstützung in demineralisiertem Wasser gründlich gespült. Durch aufeinanderfolgende Behandlungen in einer Lösung von Zinn-II-chlorid, in Wasser und in einer Lösung von Palladiumchlorid sowie abschließendem Spülen in demineralisiertem Wasser entsteht nach bekanntem Verfahren eine für chemisch stromlose Metallabscheidungen katalytisch wirkende Keimschicht auf der Keramikoberfläche. Auf dieser wird aus einem derzeit handelsüblichen chemischen Kupferbad eine ungefähr 0,2 µm dicke Kupfer-Basisschicht abgeschieden. Anschließend wird diese in einem derzeit handelsüblichen galvanischen Kupfersulfatbad, in welchem Teilchen aus Graphit mit einer Korngröße von kleiner als 10 µm und mit einer Konzentration von ungefähr 15 g/l suspendiert sind, auf eine Gesamtschichtdicke von ungefähr 5 µm verstärkt. Die entstandenen Kupferschichten, die ein dunkelmattes Aussehen haben, werden ungefähr 10 Minuten lang bei einer Temperatur von ungefähr 400°C unter Wasserstoff geglüht. Bei der anschließenden mikroskopischen Untersuchung werden keine Blasen in der Kupferschicht gefunden.

Beispiel 5

Keramiksubstrate aus Aluminiumoxid werden wie in Beispiel 1 vorbehandelt und chemisch stromlos mit einer ungefähr 0,2 µm dicken Kupfer-Basisschicht versehen. Anschließend wird auf eine Schichtdicke von ungefähr 7 µm verstärkt aus einem derzeit handelsüblichen galvanischen Kupferbad, in welchem Teilchen suspendiert sind, die Polyacrylsäureester enthalten, deren Konzentration ungefähr 10 g/l beträgt und die durch Zugabe eines Dispersions-Präparates entstanden sind, das derzeit unter dem Handelsnamen "Acronal 4F" erhältlich ist. Die Kupferschichten haben ein seidenmattes Aussehen und zeigen nach einer Temperung (thermische Nachbehandlung) von 10 Minuten bei einer Temperatur von ungefähr 400°C unter Stickstoff keinerlei Blasen.

Die Erfindung ist nicht auf die beschriebenen Ausführungsbeispiele beschränkt, sondern sinngemäß auf weitere an wendbar. So ist es beispielsweise möglich, statt der erwähnten $Al_2O_3$-Teilchen in die Metallschicht auch Teilchen aus $SiO_2$, $Si_3N_4$ oder SiC einzulagern.

**Patentansprüche**

1. Verfahren zur naßchemischen Metallisierung einer elektrisch isolierenden Oberfläche, insbesondere einer Keramikoberfläche, bei welchem
—die Oberfläche gereinigt und möglicherweise aufgerauht wird,
—auf der Oberfläche anschließend stromlos chemisch eine Keimschicht erzeugt wird,
—auf der Keimschicht stromlos chemisch eine elektrisch leitende, gas- und dampfdurchlässige metallische Basisschicht abgeschieden wird,
—auf der Basisschicht galvanisch eine Metallschicht abgeschieden wird und
—nach dem Abscheiden der Metallschicht eine thermische Nachbehandlung, bei der flüchtige Bestandteile aus den abgeschiedenen Schichten entfernt werden, durchgeführt wird, dadurch gekennzeichnet,

—daß aus einem Elektrolyten, der im wesentlichen anorganische Bestandteile enthält, eine Metallschicht mit darin eingelagerten Teilchen galvanisch abgeschieden wird und

—daß das Volumen der Teilchen durch die thermische Nachbehandlung verringert wird, so daß eine gas- sowie dampfdurchlässige Metallschicht entsteht.

2. Verfahren nach Anspruch 1, dadurch gekennzeichnet, daß der Elektrolyt mindestens eines der Anionen $SO_4^{2-}$, $PO_4^{3-}$, $P_2O_7^{4-}$, $CN^-$, $Cl^-$, $BF_4^-$ und/oder $NH_2SO_3^-$ enthält.

3. Verfahren nach Anspruch 1 oder Anspruch 2, dadurch gekennzeichnet, daß der Elektrolyt feindispers verteilte anorganische Teilchen enthält, deren Schmelpunkt größer als 200K ist, und daß die anorganischen Teilchen in der Metallschicht abgeschieden werden.

4. Verfahren nach einem der vorhergehenden Ansprüche, dadurch gekennzeichnet, daß der Elektrolyt anorganische Teilchen enthält, deren Durchmesser kleiner als 10 µm ist.

5. Verfahren nach einem der vorhergehenden Ansprüche, dadurch gekennzeichnet, daß der Elektrolyt anorganische kolloidale Teilchen enthält, deren Durchmesser kleiner als 1 µm ist.

6. Verfahren nach einem der vorhergehenden Ansprüche, dadurch gekennzeichnet, daß die Teilchen innerhalb des Elektrolyten erzeugt werden aufgrund einstellbarer Konzentrationsverhältnisse und/oder aufgrund des einstellbaren pH-Wertes.

7. Verfahren nach einem der vorhergehenden Ansprüche, dadurch gekennzeichnet, daß die Metallschicht auf einer Keramikoberfläche abgeschieden wird und im wesentlichen Kupfer enthält und daß in der Metallschicht Keramikteilchen eingelagert werden, deren Durchmesser kleiner als 10 µm ist und deren Konzentration ungefähr 5% beträgt.

8. Verfahren nach einem der vorhergehenden Ansprüche, dadurch gekennzeichnet,

—daß in dem Elektrolyten Teilchen, deren Durchmesser in einem Bereich von 0,1 µm bis 20 µm, suspendiert werden,

—daß die Teilchen bei der Abscheidung der Metallschicht in diese eingelagert werden und

—daß durch die Nachbehandlung das Volumen der in der Metallschicht eingelagerten Teilchen verringert wird.

9. Verfahren nach einem der vorhergehenden Ansprüche, dadurch gekennzeichnet, daß die Teilchen Kohlenstoff und/oder anorganische bzw. organische Bestandteile enthalten.

**Revendications**

1. Procédé de métallisation chimique par voie humide d'une surface électriquement isolante, en particulier d'une surface céramique, dans lequel:

—la surface est nettoyée et si possible rendue rugueuse,

—une couche d'amorçage est ensuite produite sur la surface par voie chimique sans courant,

—une couche de base métallique électriquement conductrice, perméable aux gaz et à la vapeur est déposée chimiquement sans courant sur la couche d'amorçage,

—une couche métallique est déposée par galvanisation sur la couche de base et

—après le dépôt de la couche métallique a lieu un posttraitement thermique dans lequel les constituants volatils sont éliminés des couches déposées, caractérisé en ce que

—une couche métallique dans laquelle sont incorporées des particules est déposée par galvanisation à partir d'un électrolyte qui contient des constituants essentiellement inorganiques et

—le volume des particules est réduit par le posttraitement thermique de sorte qu'il en résulte une couche métallique perméable aux gaz et à la vapeur.

2. Procédé selon la revendication 1, caractérisé en ce que l'électrolyte contient au moins l'un des anions $SO_4^{2-}$, $PO_4^{3-}$, $P_2O_7^{4-}$, $CN^-$, $Cl^-$, $BF_4^-$ et/ou $NH_2SO_3^-$.

3. Procédé selon la revendication 1 ou la revendication 2, caractérisé en ce que l'électrolyte contient des particules inorganiques réparties de façon finement dispersée, dont le point de fusion est supérieur à 200 K, et en ce que les particules inorganiques sont déposées dans la couche métallique.

4. Procédé selon l'une des revendications précédentes, caractérisé en ce que l'électrolyte contient des particules inorganiques dont le diamètre est inférieur à 10 µm.

5. Procédé selon l'une des revendications précédentes, caractérisé en ce que l'électrolyte contient des particules colloïdales inorganiques dont le diamètre est inférieur à 1 µm.

6. Procédé selon l'une des revendications précédentes, caractérisé en ce que les particules sont produites à l'intérieur de l'électrolyte par suite de rapports de concentration réglables et/ou par suite du pH réglable.

7. Procédé selon l'une des revendications précédentes, caractérisé en ce que la couche métallique est déposée sur une surface céramique et contient essentiellement du cuivre et en ce que dans la couche métallique sont incorporées des particules céramiques dont le diamètre est inférieur à 10 µm et dont la concentration est d'environ 5%.

8. Procédé selon l'une des revendications précédentes, caractérisé en ce que

—des particules dont la diamètre est compris dans une gamme de 0,1 µm à 20 µm sont mises en suspension dans l'électrolyte,

—les particules sont incorporées dans la couche métallique lors du dépôt de celles-ci et

—le volume des particules incorporées dans la couche métallique est réduit per le post-traitement.

9. Procédé selon l'une des revendications précédentes, caractérisé en ce que les particules contiennent du carbone et/ou des constituants inorganiques ou organiques.

## Claims

1. Method for the wet chemical metallising of an electrically insulating surface, in particular a ceramic surface, in which method
— the surface is cleaned and possibly roughened,
— a seed layer is substantially produced free of current chemically on the surface,
— an electrically conductive metallic base layer, which is permeable by gas and vapour, is precipitated free of current chemically on the seed layer,
— a metal layer is precipitated galvanically on the base layer and
— a thermal finishing treatment, in which volatile components are removed from the precipitated layers, is performed after the precipitation of the metal layer, characterised thereby,
— that a metal layer with particles embedded therein is precipitated galvanically out of an electrolyte which substantially contains inorganic components and
— that the volume of the particles is reduced by the thermal finishing treatment so that a metal layer, which is permeable by gas as well as vapour, arises.

2. Method according to claim 1, characterised thereby, that the electrolyte contains at least one of the anions $SO_4^{2-}$, $PO_4^{3-}$, $P_2O_7^{4-}$, $CN^-$, $Cl^-$, $BF_4^-$ and/or $NH_2SO_3^-$.

3. A method according to claim 1 or claim 2, characterised thereby, that the electrolyte contains finely dispersed distributed inorganic particles, the melting point of which is higher than 200°K and that the inorganic particles are precipitated in the metal layer.

4. Method according to one of the preceding claims, characterised thereby, that the electrolyte contains inorganic particles, the diameter of which is smaller than 10 micrometers.

5. Method according to one of the preceding claims, characterised thereby, that the electrolyte contains inorganic colloidal particles, the diameter of which is smaller than 1 micrometer.

6. Method according to one of the preceding claims, characterised thereby, that the particles are produced within the electrolyte by reason of adjustable concentration ratios and/or by reason of the adjustable pH value.

7. Method according to one of the preceding claims, characterised thereby, that the metal layer is precipitated on a ceramic surface and contains substantially copper and that ceramic particles, the diameter of which is smaller than 10 micrometers and the concentration of which amounts to approximately 5%, are embedded in the metal layer.

8. Method according to one of the preceding claims, characterised thereby,
— that particles, the diameter of which lies in a range of 0.1 to 20 micrometers, are suspended in the electrolyte,
— that the particles are embedded in the metal layer during the precipitation thereof and
— that the volume of particles embedded in the metal layer is reduced by the finishing treatment.

9. Method according to one of the preceding claims, characterised thereby, that the particles contain carbon and/or inorganic or organic components.